# EUROPÄISCHE PATENTSCHRIFT

(11) **EP 1 842 723 B1**
(45) Veröffentlichungstag und Bekanntmachung des Hinweises auf die Patenterteilung: **18.02.2009**
(21) Anmeldenummer: 07012730.3
(22) Anmeldetag: 24.03.2004
(51) Int. Cl.: B60Q 1/04, F21S 8/10, F21S 8/00

(54) **Scheinwerfer und Scheinwerferelement**
Headlamp and headlamp element
Phare et élément de phare

(30) Priorität: 31.03.2003 DE 10314524
(43) Veröffentlichungstag der Anmeldung: 10.10.2007
(62) Teilanmeldung aus: 04722798.8
(73) Patentinhaber: OSRAM Opto Semiconductors GmbH, 93055 Regensburg (DE)
(72) Erfinder: Bogner, Georg, 93138 Lappersdorf (DE); Grötsch, Stefan, 93077 Lengfeld-Bad Abbach (DE); Reill, Joachim, 93197 Zeitlarn (DE)
(74) Vertreter: Epping - Hermann - Fischer

(56) Entgegenhaltungen:
- EP-A- 0 523 927
- DE-A- 19 621 148
- US-A- 5 727 108

## Beschreibung

Die Erfindung betrifft ein Scheinwerferelement nach dem Oberbegriff des Anspruchs 1 sowie einen Scheinwerfer mit einer Vielzahl derartiger Scheinwerferelemente.

Diese Patentanmeldung beansprucht die Priorität der deutschen Patentanmeldung 10314524.9, deren Offenbarungsgehalt hiermit durch Rückbezug aufgenommen wird.

Ein aus Scheinwerferelementen bestehender Scheinwerfer ist beispielsweise in der US 6,527,411 B1 beschrieben. Lichtaustrittsenden der Scheinwerferelemente bzw. die Scheinwerferelemente selbst werden dabei kreisförmig angeordnet, wobei ein zentrales Scheinwerferelement von einer Vielzahl weiterer Scheinwerferelemente umgeben ist. Bei einem derartigen Scheinwerfer können insbesondere Leuchtdioden (LEDs) verwendet werden, die beispielsweise den Vorteil einer langen Lebensdauer, eines schnellen Ansprechens sowie eines hohen elektrischen Wirkungsgrades haben, was zu geringerem Wartungsaufwand und geringerem Energieverbrauch führt.

Ein Scheinwerfer gemäß der US 6,527,411 B1 ist jedoch wegen seiner kreisrunden Form für viele Anwendungen, bei denen eine definierte Abstrahlcharakteristik des Scheinwerfers benötigt wird, nicht oder nur begrenzt anwendbar. Ein derartiges Beispiel ist ein Kfz-Scheinwerfer, für den in gängigen Standards (z.B. ECE in Deutschland) eine Abstrahlcharakteristik mit wohldefinierter Geometrie eines Lichtkegels, sowie mit abrupten hell/dunkel-Übergängen vorgeschrieben ist. Zudem gibt es Anwendungen, bei denen eine veränderliche Abstrahlcharakteristik eines Scheinwerfers nötig oder vorteilhaft ist.

Aufgabe der vorliegenden Erfindung ist, einen Scheinwerfer zu entwickeln, der bei einfachem Aufbau eine Vielzahl verschiedener Abstrahlcharakteristiken sowie veränderbare Abstrahlcharakteristiken zuläßt. Zudem ist es Aufgabe der vorliegenden Erfindung, ein Scheinwerferelement zu entwickeln, das für derartige Scheinwerfer besonders geeignet ist.

Diese Aufgabe wird durch ein Scheinwerferelement mit den Merkmalen des Patentanspruches 1 und durch einen Scheinwerfer mit einer Vielzahl derartiger Scheinwerferelemente gelöst.

Erfindungsgemäß sind bei einem Scheinwerfer der eingangs genannten Art zumindest einige der Scheinwerferelementausgänge in mindestens zwei Gruppen derart angeordnet, daß die Anordnung mindestens einer der Gruppen und/oder mindestens eine Gesamtanordnung von Scheinwerferelementausgängen mehrerer Gruppen im wesentlichen einer gewünschten Abstrahlcharakteristik des Scheinwerfers entspricht, daß sie insbesondere eine Form ergibt, die im wesentlichen einer Querschnittsform eines gewünschten Scheinwerferkegelsentspricht. Der Scheinwerfer ist zudem derart beschaffen, daß die zu den Scheinwerferelementausgängen einer Gruppe gehörenden Halbleiterchips jeweils unabhängig von anderen Halbleiterchips in Betrieb genommen werden können.

Mit Scheinwerferkegel ist hierbei sowie im Folgenden ein beliebig geformtes Volumen gemeint, das durch das Scheinwerferlicht durchleuchtet ist, wobei Bereiche ausgeschlossen sind, in denen die Helligkeit mehr als eine Größenordnung geringer ist als die maximale Helligkeit bei gleichem Abstand zum Scheinwerfer. Unter Abstrahlcharakteristik sind eine oder mehrere Eigenschaften des Scheinwerferkegels, wie z.B. Lichtintensität in verschiedenen Raumwinkeln, hell-/dunkelÜbergänge oder eine Querschnittsform zu verstehen. Mit Querschnittsform ist die Form eines Querschnitts des Scheinwerferkegels in einer Ebene senkrecht zu einer Hauptabstrahlrichtung des Scheinwerfers gemeint.

Bei einem derartigen Scheinwerfer lassen sich allein durch die geometrische Anordnung der Scheinwerferelementausgänge bereits eine Vielzahl verschiedener Abstrahlcharakteristiken erreichen. Zudem ist auf einfache Weise ein Scheinwerfer realisiert, dessen Abstrahlcharakteristik durch Ein- und Ausschalten der zu den Scheinwerferelementausgängen verschiedener Gruppen gehörenden Halbleiterchips veränderbar ist.

Bei einem Scheinwerferelement gemäß der Erfindung ist das Primäroptikelement jeweils ein optischer Konzentrator. Dabei ist der Lichteingang der eigentliche Konzentratorausgang, so dass Licht verglichen mit der üblichen Anwendung eines Konzentrators zum Fokussieren in umgekehrter Richtung durch diesen läuft und somit nicht konzentriert wird, sondern den Konzentrator mit verringerter Divergenz durch den Lichtausgang verlässt.

In einer besonders bevorzugten Ausführungsform ist das primäroptikelement ein CPC-, CEC- oder CHC-artiger Konzentrator, womit hierbei sowie im Folgenden ein Konzentrator gemeint ist, dessen reflektierende Seitenwände zumindest teilweise und/oder zumindest weitestgehend die Form eines zusammengesetzten parabolischen Konzentrators (compound parabolic concentrator, CPC), eines zusammengesetzten elliptischen Konzentrators (compound elliptic concentrator, CEC) und/oder eines zusammengesetzten hyperbolischen Konzentrators (compound hyperbolic concentrator, CHC) aufweist.

Als Alternative zu dem CPC-, CEC- oder CHC-artigen Konzentrator weist der Konzentrator bevorzugt den Lichteingang mit dem Lichtausgang verbindende Seitenwände auf, entlang denen direkte Verbindungslinien zwischen dem Lichteingang und dem Lichtausgang im wesentlichen gerade verlaufen. Die Seitenwände weisen mit Vorteil statt paraboloid-, ellipsoid- oder hyperboloid-artig gekrümmten Seitenwänden im wesentlichen gerade verlaufende Seitenwände auf, so dass das Primäroptikelement beispielsweise eine Grundform eines Pyramidenstumpfes oder eines Kegelstumpfes aufweist.

Derart gestaltete Primäroptik- bzw. Scheinwerferelemente ermöglichen eine effiziente Verringerung der Divergenz von Licht, wodurch sich Scheinwerfer mit ausreichender Helligkeit und wohldefinierter Abstrahlcharakteristik herstellen lassen.

Die vorgehend sowie im Folgenden beschriebenen Ausführungsformen und Vorteile von Primäroptikelementen beziehen sich sowohl auf den erfindungsgemäßen Scheinwerfer als auch auf das erfindungsgemäße Scheinwerferelement, sofern sie auf dieses zutreffen.

Mit besonderem Vorteil ist der Öffnungswinkel eines vom Lichtausgang des Primäroptikelements emittierten Lichtkegels zwischen 0 und 60°, bevorzugt zwischen 0 und 40°, besonders bevorzugt zwischen 0 und 20° groß, wobei die Grenzen jeweils einbezogen sind. Analog zum Scheinwerfer bedeutet Lichtkegel hier und im Folgenden ein beliebig geformtes Volumen, das durch das vom Lichtausgang des Primäroptikelements emittierten Lichts durchleuchtet ist, wobei Bereiche ausgeschlossen sind, in denen die Helligkeit mehr als eine Größenordnung geringer ist als die maximale Helligkeit bei gleichem Abstand zum Lichtausgang. Ein Lichtkegel in diesem Sinne bezieht sich nicht auf die Form eines Kegels im mathematischen Sinne und kann demnach mehr als einen Öffnungswinkel aufweisen. Ist das der Fall, so bezieht sich die obige Aussage auf den maximalen Öffnungswinkel.

Dadurch, dass die Divergenz eines Lichtes durch das Primäroptikelement jeweils auf ein derartiges Maß begrenzt ist, lässt sich eine höhere Leuchtdichte pro Scheinwerferelement erreichen. Zudem ergibt sich dadurch eine größere Anzahl möglicher Abstrahlcharakteristiken des Scheinwerfers, die sich durch die Anordnung der Scheinwerferelementausgänge erreichen lässt, da die von den Scheinwerferlementen abgestrahlten Lichtkegel bei gleicher Anordnung weniger überlappen und beispielsweise eine bessere Auflösung bezüglich der Geometrie eines resultierenden Lichtkegels des Scheinwerfers erreicht werden kann.

Um einen derart geringen Öffnungswinkel eines vom Primäroptikelement emittierten Lichtkegels zu realisieren, weist der Lichtausgang des Primäroptikelements mit besonderem Vorteil eine Lichteingangsfläche oder eine Lichteingangsöffnung auf, deren Größe kleiner als oder gleich der zweifachen Chipauskoppelfläche ist. Besonders bevorzugt ist die Größe der Lichteingangsfläche oder der Lichteingangsöffnung maximal 1,5 mal so groß, insbesondere maximal 1,1 mal oder 1,05 mal so groß wie die Chipauskoppelfläche.

Die Größe der Lichteingangsfläche oder der Lichteingangsöffnung ist bevorzugt größer oder nicht wesentlich kleiner als die Chipauskoppelfläche.

Der so beschaffene Lichteingang des Primäroptikelements eignet sich nicht nur für eine starke Verringerung der Divergenz eines Lichtkegels, sondern ermöglicht auch eine signifikante Miniaturisierung des Primäroptikelements und somit eine Herstellung eines kompakten Scheinwerfers mit einer hohen emittierten Lichtdichte.

Bevorzugt sind zumindest Teile der Scheinwerferelementausgänge von mindestens einer Gruppe dicht gepackt, besonders bevorzugt sind sie lückenlos angeordnet. Dadurch lässt sich eine höhere Leuchtdichte und eine bessere Homogenität eines Scheinwerferkegels erreichen.

Mit Vorteil sind die Halbleiterchips und/oder die Scheinwerferelementausgänge zumindest teilweise oder zumindest in Teilgruppen matrixartig, d.h. regelmäßig in Zeilen und Spalten angeordnet.

In einer besonders bevorzugten Ausführungsform ist der Scheinwerfer für die Verwendung in einem Kraftfahrzeug vorgesehen. Hierbei entspricht die Anordnung mindestens einer ersten Gruppe von Scheinwerferelementausgängen und/oder mehrerer erster Gruppen zusammen im Wesentlichen einer Abstrahlcharakteristik eines Abblendlichts, insbesondere einer Querschnittsform eines Lichtkegels eines Abblendlichts. Die Anordnung mindestens einer zweiten Gruppe und/oder mehrerer zweiter Gruppen zusammen ist derart, dass sie zusammen mit der Anordnung der ersten Gruppe oder mehrerer erster Gruppen zusammen oder alleine im Wesentlichen einer Abstrahlcharakteristik eines Fernlichts, insbesondere einer Querschnittsform eines Lichtkegels eines Fernlichts entspricht.

Ein derartiger Kfz-Scheinwerfer lässt sich auf einfache Weise jeweils den erforderlichen Standards (z.B. ECE in Deutschland) anpassen und bietet zudem die Möglichkeit, einen durch Zu- und Abschalten von Halbleiterchips veränderbaren Lichtkegel für Abblend- und/oder Fernlicht zu erzeugen.

Letzteres wird in einer weiteren besonders bevorzugten Ausführungsform genutzt, um einen "mitlenkenden" Scheinwerfer zu erhalten. Dabei weist der Scheinwerfer mehrere erste und zweite Gruppen auf, wobei bei Verwendung der Scheinwerferelemente der ersten und/oder der zweiten Gruppen abhängig von der Lenkstellung des Kraftfahrzeugs jeweils nur Halbleiterchips einiger der Gruppen in Betrieb sind, derart, dass der vom Scheinwerfer abgestrahlte Lichtkegel der Fahrtrichtung des Kraftfahrzeugs zumindest teilweise folgt.

Vorteilhafterweise ist der Lichtausgang des entsprechenden Primäroptikelements bei einer Ausführungsform jeweils der Scheinwerferelementausgang.

Bevorzugt ist jedem Primäroptikelement ein optischer Wellenleiter, bevorzugt eine Glasfaser oder ein Bündel mit mehreren Glasfasern, mit einer Lichteingangsfläche und einer Lichtausgangsfläche, in Abstrahlrichtung der Primäroptik nachgeordnet, in den zumindest ein Großteil des aus dem Lichtausgang des jeweiligen Primäroptikelements ausgestrahlten Lichtes durch die Lichteingangsfläche übergeht.

Die Lichtausgangsfläche des optischen Wellenleiters ist mit besonderem Vorteil jeweils der Scheinwerferelementausgang. Dadurch lassen sich die Scheinwerferelementausgänge auf einfache Weise unabhängig von der Anordnung der Halbleiterchips und/oder der Primäroptikelemente anordnen, was weitere Flexibilität bei der Gestaltung des Scheinwerfers mit sich bringt. Beispielsweise lassen sich die Halbleiterchips mit weiterem Abstand voneinander anordnen, um eine verbesserte Abfuhr einer bei Betrieb eines Halbleiterchips entstehenden Wärme von diesem zu erreichen. Die Scheinwerferelementausgänge können dabei dennoch in einer dichten Packung angeordnet sein.

Der optische Wellenleiter schließt zweckmäßigerweise jeweils mit der Lichteingangsfläche direkt an den Lichtausgang des entsprechenden Primäroptikelements an.

Mittels eines Verbindungssteckers ist der optische Wellenleiter jeweils mit Vorteil mit dem entsprechenden Primäroptikelement verbunden und/oder ist der optische Wellenleiter jeweils mit der Lichteingangsfläche mittels eines Klebstoffs an den Lichtausgang des entsprechenden Primäroptikelements angebracht und mit dem Primäroptikelement verbunden. Somit sind das Primäroptikelement und der Wellenleiter zueineander fixiert und es wird gewährleistet, dass möglicht viel Licht aus dem Lichtausgang in den Wellenleiter übergeht.

Mit besonderem Vorteil ist der optische Wellenleiter jeweils mittels einem Verbindungsstecker mit dem entsprechenden Primäroptikelement verbunden und ist die Vielzahl der Verindungsstecker miteinander verbunden oder einstückig ausgebildet.

Ebenso mit Vorteil ist der optische Wellenleiter jeweils mittels einem Verbindungsstecker mit dem entsprechenden Primäroptikelement verbunden und ist der Verbindungsstecker mit dem Primäroptikelement einteilig ausgebildet. Somit lassen sich diese gemeinsam herstellen und müssen nicht mehr miteinander verbunden oder separat montiert werden.

Bevorzugt ist der optische Wellenleiter mit dem entsprechenden Primäroptikelement einteilig ausgebildet. Auch dadurch kann eine vereinfachte Herstellung und/oder eine vereinfachte Montage erreicht werden. Zudem wird dadurch ein weiterhin optimierter Lichtübertrag vom Primäroptikelement in den Wellenleiter erreicht.

Bei einer bevorzugten Ausführungsform des Scheinwerfers ist das Primäroptikelement jeweils ein optischer Konzentrator, besonders bevorzugt ein CPC-, CEC- oder CHC-artiger optischer Konzentrator. Dabei ist der Lichteingang der eigentliche Konzentratorausgang, so dass Licht verglichen mit der üblichen Anwendung eines Konzentrators in umgekehrter Richtung durch diesen läuft und somit nicht konzentriert wird, sondern den Konzentrator mit verringerter Divergenz durch den Lichtausgang verlässt.

Der Konzentrator weist in einem Bereich auf der Seite des Lichteingangs bevorzugt eine Querschnittsfläche in Form eines regelmäßigen Vielecks, besonders bevorzugt eine quadratische Querschnittsfläche auf. In einem Bereich auf der Seite des Lichtausgangs weist er bevorzugt ebenfalls eine Querschnittsfläche in Form eines regelmäßigen Vielecks, besonders bevorzugt eine drei-, vier-, sechs- oder achteckige Querschnittsfläche auf. Zwischen diesen Bereichen geht die Querschnittsfläche von der einen in die andere Form über. Der Lichteingang des Konzentrators lässt sich somit an die übliche Form von Halbleiterchips anpassen und der Lichtausgang lässt sich beispielsweise derart gestalten, dass sich die Lichtausgänge mehrerer Primäroptikelemente regelmäßig und lückenlos anordnen lassen, was insbesondere vorteilhaft ist, wenn der Lichtausgang der Scheinwerferelementausgang ist.

In einer vorteilhaften Ausführungsform weist der Konzentrator einen einen Hohlraum definierenden Grundkörper auf, dessen Innenwand für ein von dem Halbleiterchip ausgesandtes Licht reflektierend ist und/oder dessen Innenwand im Wesentlichen mit einer Schicht oder Schichtenfolge, bevorzugt mit einer metallischen Schicht versehen ist, die für ein von dem Halbleiterchip ausgesandtes Licht reflektierend ist.

Alternativ ist der Konzentrator mit Vorteil ein dieelektrischer Konzentrator, dessen Grundkörper ein aus einem dieelektrischen Material mit geeignetem Brechungsindex bestehender Vollkörper ist, so dass über den Lichteingang eingekoppeltes Licht in diesem durch Totalreflexion an der den Lichteingang mit dem Lichtausgang verbindenden seitlichen Grenzfläche des Vollkörpers zur Aussenatmosphäre reflektiert wird. Dies hat den Vorteil, dass es aufgrund von Reflexionen im Konzentrator praktisch keine Lichtverluste gibt.

Mit besonderem Vorteil weist der dielektrische Konzentrator als Lichtausgang eine linsenartig gewölbte Grenzfläche auf, die z.B. sphärisch oder asphärisch gewölbt sein kann. Dadurch kann eine weitere Verringerung der Divergenz eines Lichtkegels erzielt werden. Der Lichtausgang ist bevorzugt in der Art einer asphärischen Linse gewölbt, wodurch etwa der Größe der Chipauskoppelfläche Rechnung getragen werden kann. Sphärische Linsen sind für punktförmige Lichtquellen optimal und können bei nichtpunktförmigen Lichtquellen signifikant schlechtere Eigenschaften hinsichtlich einer Verringerung der Divergenz eines Lichtkegels aufweisen.

Bei einer weiteren Ausführungsform ist der dielektrische Konzentrator mit Vorteil zumindest teilweise mit einer Schicht oder Schichtenfolge, bevorzugt mit einer metallischen Schicht versehen, die für von dem jeweiligen Halbleiterchip ausgesandtes Licht reflektierend ist. Dies kann z.B. vorteilhaft sein, wenn der Halbleiterchip in dem Material des Konzentrators eingebunden ist, um zu verhindern, dass die Strahlung, die zu Beginn die Bedingung der Totalreflexion nicht erfüllt, seitlich aus dem Konzentrator ausgekoppelt wird.

Bevorzugt ist der Konzentrator dem Halbleiterchip in dessen Hauptabstrahlrichtung nachgeordnet und besteht zwischen der Chipauskoppelfläche und dem Lichteingang des Konzentrators ein Spalt. Dieser ist mit Vorteil weistestgehend frei von fester oder viskoser Materie.

Dadurch wird erreicht, dass insbesondere Strahlen, die in besonders großem Winkel gegenüber der Hauptabstrahlrichtung des Halbleiterchips emittiert werden und die den Lichtkegel am Lichtausgang zu stark aufweiten würden, nicht auf den Lichteingang treffen sondern seitlich an diesem vorbeilaufen. Im Falle eines dielektrischen Konzentrators führt der Spalt dazu, dass von den Strahlen ein desto größerer Anteil an der Grenzfläche des Lichteingangs reflektiert wird, je größer der Einfallswinkel von diesen ist. Somit wird jeweils der hochdivergente Anteil des in den Konzentrator gelangenden Lichts abgeschwächt.

Insbesondere in diesem Zusmmenhang ist es besonders vorteilhaft, wenn das Scheinwerferelement ein oder mehrere Reflektorelemente aufweist, die derart angeordnet und/oder von solcher Form sind, dass ein Teil der Lichtstrahlen, die nicht direkt vom Halbleiterchip in den Konzentrator gelangen, an diesen mehrfach reflektiert werden und mit einem geringeren Winkel zur Hauptabstrahlrichtung des Halbleiterchips auf den Lichteingang des Konzentrators gelenkt werden. Dies führt zur Erhöhung der Intensität des in den Konzentrator gelangenden Lichts.

Zweckmäßigerweise besteht der Grundkörper des Konzentrators aus einem transparenten Glas, einem transparenten Kristall oder einem transparenten Kunststoff und ist bevorzugt in einem Spritzpress- und/oder einem Spritzgußverfahren gefertigt.

Besonders bevorzugt ist das Material des Grundkörpers gegenüber einer von dem Halbleiterchip ausgesandten Strahlung, insbesondere gegenüber einer elektromagnetischen Strahlung aus dem blauen oder UV Spektralbereich resistent. Das Material weist hierfür z.B. Silikon auf oder besteht aus diesem.

Der Halbleiterchip ist in einer vorteilhaften Ausführungsform eine elektromagnetische Strahlung emittierende Diode, bevorzugt eine elektromagnetische Strahlung emittierende Diode mit zumindest näherungsweise lambertscher Abstrahlcharakteristik, besonders bevorzugt ein Dünnfilm-Leuchtdioden-Chip ist.

Ein Dünnfilm-Leuchtdioden-Chip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

In einer bevorzugten Ausführungsform des Scheinwerfers ist der Diode in Abstrahlrichtung ein Lumineszenz-Konversionsmaterial nachgeordnet, welches zumindest einen Teil einer von der Dünnfilm-Leuchtdiode ausgesandten elektromagnetischen Strahlung wellenlängenkonvertiert, d.h. welches diese Strahlung absorbiert und daraufhin Strahlung einer anderen Wellenlänge emittiert. Eine resultierende Strahlung ergibt sich durch eine Mischung der wellenlängenkonvertierten Strahlung mit der von der Diode ausgesandten Strahlung, so daß sich dadurch insbesondere auch weißes Licht erzeugen läßt, welches bei vielen Anwendungen von Scheinwerfern benötigt wird.

Die von dem Dünnfilm-Leuchtdiodenchip ausgesandte Strahlung kann auch im Wesentlichen vollständig durch das Lumineszenz-Konversionsmaterial wellenlängenkonvertiert werden, beispielsweise um eine nicht sichtbare Strahlung in sichtbares Licht umzuwandeln. Bei der Verwendung von mindestens zwei verschiedenen Leuchtstoffen kann auch auf diese Weise insbesondere weißes Licht erzeugt werden. Derartige organische oder anorganische Leuchtstoffpartikel sind beispielsweise in der WO 98/12757 beschrieben, deren Inhalt insofern hiermit durch Rückbezug aufgenommen wird.

Den Scheinwerferelementen ist mit Vorteil in deren Hauptabstrahlrichtung eine Sekundäroptik nachgeordnet, durch die das von ihnen emittierte Licht eine weitere Verringerung der Divergenz erfährt und/oder gemischt wird. Diese Sekundäroptik ist in eine weiteren Ausführungsform zweckmäßigerweise als Kondensorlinse ausgebildet.

Mit besonderem Vorteil sind die Primäroptikelemente mehrerer Scheinwerferelemente einteilig miteinander ausgebildet. Dies kann sowohl eine Herstellung der Primäroptikelemente als auch eine Montage von diesen in einem Scheinwerfer signifikant vereinfachen, was beispielsweise zu geringeren Herstellungskosten führen kann.

Bei einer bevorzugten Ausführungsform des Scheinwerfers sind die Halbleiterchips auf je einem Träger angeordnet, auf dem sie jeweils von einem Rahmen umgeben sind, an oder in dem das Primäroptikelement angebracht ist und von dem dieses gehalten wird und/oder durch das dieses relativ zur Chipauskoppelfläche justiert ist.

Zumindest einige der Träger und/oder jeweils der Träger und der Rahmen sind vorteilhafterweise miteinander einteilig ausgebildet.

Mit besonderem Vorteil sind die Träger mehrerer Halbleiterdioden zeilenartig nebeneinander in mindestens einem Streifen angeordnet. Dadurch kann eine verbesserte Abfuhr von bei Betrieb der Halbleiterchips entstehender Wärme von diesen erreicht werden.

In einer weiteren Ausführungsform des Scheinwerfers ist bzw. sind die Innenfläche des Rahmens und/oder freie Flächen der zur Abstrahlrichtung des Scheinwerfers gewandten Oberfläche des Trägers für von dem jeweiligen Halbleiterchip ausgesandtes Licht reflektierend. Zusätzlich oder alternativ ist bzw. sind diese zumindest teilweise mit einer Schicht oder Schichtenfolge, bevorzugt mit einer metallischen Schicht versehen, die für von dem jeweiligen Halbleiterchip ausgesandtes Licht reflektierend ist.

Weitere Vorteile, bevorzugte Ausführungsformen und Weiterbildungen des Scheinwerfers und des Scheinwerferelements ergeben sich aus den im folgenden in Verbindung mit den Figuren 1 bis 7 erläuterten Ausführungsbeispielen. Es zeigen:
- Figur 1: eine schematische Schnittansicht eines Ausführungsbeispiels eines Scheinwerferelements,
- Figur 2: eine schematische dreidimensionale Ansicht eines zweiten Ausführungsbeispiels eines Scheinwerferelements,
- Figur 3a: eine schematische dreidimensionale Ansicht eines dritten Ausführungsbeispiels eines Scheinwerferelements,
- Figur 3b: eine schematische dreidimensionale Schnittansicht des Scheinwerferelements aus Figur 3a,
- Figur 4: eine schematische Draufsicht eines Ausführungsbeispiels eines Scheinwerfers,
- Figur 5: eine schematische Draufsicht eines zweiten Ausführungsbeispiels eines Scheinwerfers,
- Figur 6: eine schematische dreidimensionale Ansicht eines Ausführungsbeispiels eines Primäroptikelementes, und
- Figur 7: eine schematische dreidimensionale Ansicht eines Ausführungsbeispiels von einteilig miteinander ausgebildeten Primäroptikelementen.

In den Ausführungsbeispielen und Figuren sind gleiche oder gleichwirkende Bestandteile jeweils mit den gleichen Bezugszeichen versehen.

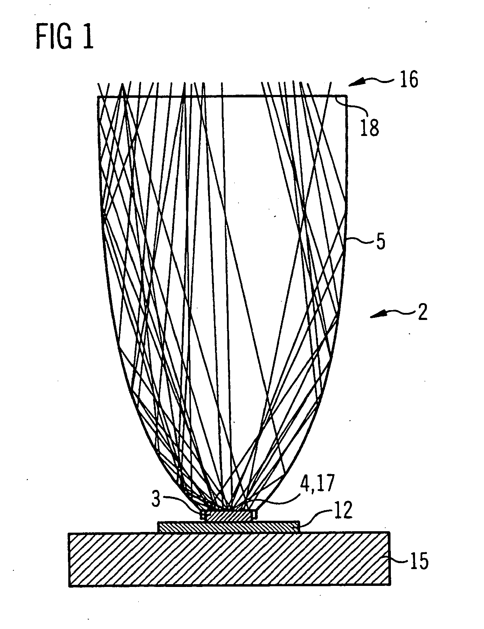

Das in Figur 1 gezeigte Scheinwerferelement 2 weist einen auf einem Träger 12 aufgebrachten Halbleiterchip 3 auf. Der Träger 12 ist wiederum auf einem zweiten Träger 15 aufgebracht, der als eine Wärmesenke für die vom Halbleiterchip 3 bei dessen Betrieb erzeugte Wärme dient.

Der Halbleiterchip ist beispielsweise ein Dünnfilm-Leuchtdiodenchip, der wie im allgemeinen Teil beschrieben beschaffen sein kann. Darüber hinaus kann die Epataxieschichtenfolge auf mindestens einem Material des Systems InₓAlyGa_{1-x-y}N oder InₓGa_{y}Al_{1-x-y}P basieren, mit 0 ≤ x ≤ 1, 0 ≤ y ≤ 1 und x+y ≤ 1. Er weist eine Chipauskoppelfläche 4 auf, die direkt an den Lichteingang 17 des Primäroptikelements anschließt.

Auf der Chipauskoppelfläche 4 kann beispielsweise ein Lumineszenz-Konversionsmaterial aufgebracht sein, das z.B. eine oder mehrere Arten von Leuchtstoffpartikeln auf der Basis von YAG:Ce aufweist. Durch das Lumineszenz-Konversionsmaterial kann entweder durch weitestgehend vollständige Konversion einer Primärstrahlung des Halbleiterchips oder durch gezielte teilweise Konversion und Mischung von Primärstrahlung und konvertierter Strahlung sichtbares Licht eines gewünschten Farbortes auf der CIE-Farbtafel, insbesondere weißes Licht erzeugt werden.

Das Primäroptikelement 5 ist ein dreidimensionaler, CPC-artiger Konzentrator, dessen Lichteingang 17 und Lichtausgang 18 kreisförmig sind, wobei der Lichtausgang 18 zugleich den Scheinweferelementausgang bildet. Durch den Lichteingang 17 tritt Licht, in Form von sichtbarer elektromagnetischer Strahlung vom Halbleiterchip 3 aus in das Primäroptikelement 5 ein. Die Strahlung wird an den den Lichteingang 17 mit dem Lichtausgang 18 verbindenden Innenwänden derart reflektiert, dass die Divergenz des Lichts deutlich verringert wird (angedeutet durch die Linien 16). Der aus dem Lichtausgang 18 abgestrahlte Lichtkegel hat beispielsweise einen Öffnungswinkel von unter 30°, z.B. etwa 9°, wohingegen der Halbleiterchip näherungsweise eine lambert'sche Abstrahlcharakteristik aufweist.

Der Grundkörper des Primäroptikelements 5 fungiert wie ein Hohlkörper, dessen Innenwand mit einem für ein von dem Halbleiterchip ausgesandtes Licht reflektierenden Material versehen ist, beispielsweise mit einer metallischen Schicht, die etwa aus A1 besteht. Hierbei kann das Licht teilweise oder ganz wellenlängenkonvertiert sein. Das Material, aus dem der Grundkörper im Wesentlichen gefertigt ist, kann ein Kunststoff wie etwa Polycarbonat sein, beispielsweise kann der Grundkörper mittels Spritzgießen aus einem solchen hergestellt sein.

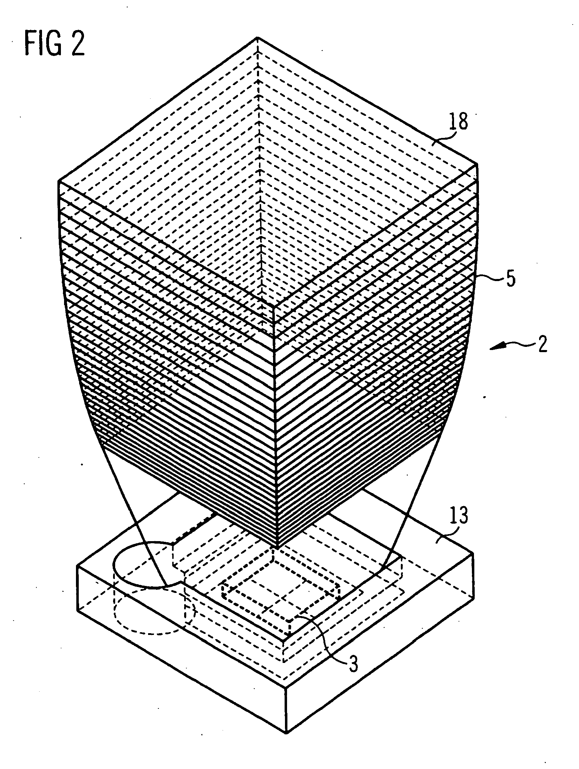

Wie in Figur 2 gezeigt, kann der Halbleiterchip 3 zusätzlich von einem Rahmen 13 umgeben sein, durch den das Primäroptikelement 5 gehalten und/oder relativ zu dem Halbleiterchip 3 justiert sein kann. Der Rahmen ist z.B. teilweise mit einer Vergußmasse gefüllt, die mit einem oder mehreren Arten von Leuchtstoffen versetzt sein kann.

Bei dem in Figur 2 gezeigten Ausführungsbeispiel weist das Scheinwerferelement 2, im Unterschied zu dem anhand Figur 1 erläuterten Ausführungsbeispiel, ein Primäroptikelement 5 in Form eines CPC-artigen Konzentrators auf, dessen Querschnitt senkrecht zu dessen Hauptabstrahlrichtung eine quadratische Form aufweist, so dass insbesondere auch dessen Lichteingang (nicht gezeigt) und Lichtausgang 18 quadratisch sind. Somit ist die Form des Primäroptikelements 5 an die Form der Chipauskoppelfläche des Halbleiterchips 3 angepasst. Dies hat zudem den Vorteil, dass sich die Lichtausgänge bzw. die Scheinwerferelementausgänge mehrerer derartiger Scheinwerferelemente 2 lückenlos in einer beliebig großen Fläche anordnen lassen.

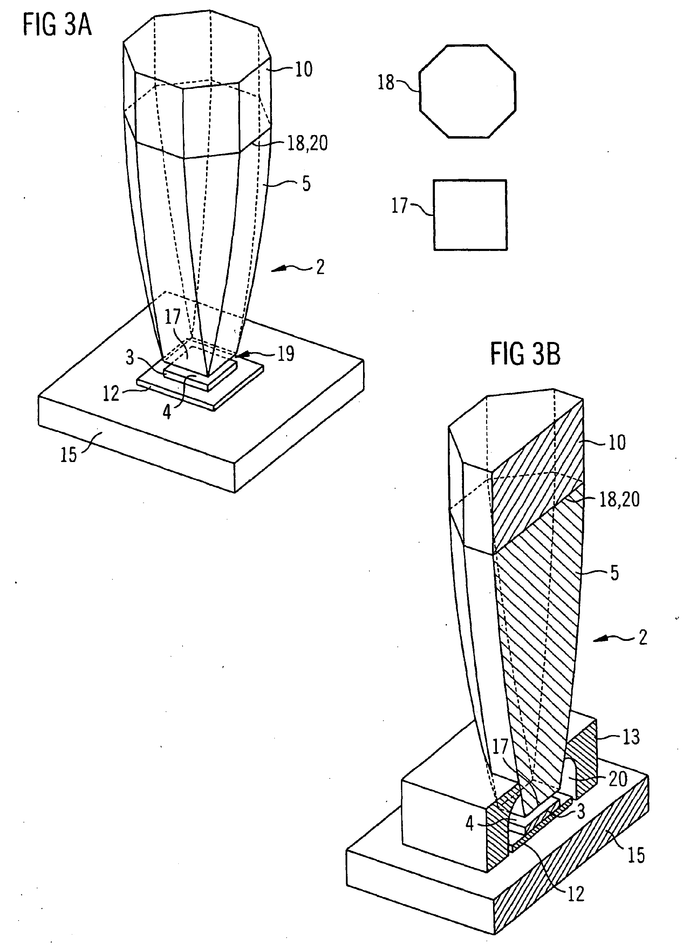

Ein weiteres Ausführungsbeispiel eines Scheinwerferelements ist in den Figuren 3a und 3b gezeigt. Bei diesem ist das Primäroptikelement 5 ein dielektrischer CPC-artiger Konzentrator, dessen Grundkörper beispielsweise aus einem transparenten Kunststoff besteht.

Der Lichteingang 17 weist eine quadratische Form auf, während der Lichtausgang 18 die Form eines regelmäßigen Achtecks aufweist (rechts neben dem Scheinwerferelement 2 jeweils in Draufsicht gezeigt). Dazwischen geht die Querschnittsform des Primäroptikelements 5 von der einen in die andere Form über. Der Lichtausgang ist durch seine Form an die Lichteingangsfläche 20 eines optischen Wellenleiters 10 angepasst, der mit dieser direkt an den Lichtausgang 18 anschließt. Der optische Wellenleiter 10 ist besipeilsweise eine Glasfaser, kann aber alternativ zu dem in den Figuren 3a und 3b gezeigten Beispiel auch mehrere dünne Glasfasern aufweisen. Die Lichtausgangsfläche des Wellenleiters 10 bildet hier den Scheinwerferelementausgang (nicht gezeigt).

Der optische Wellenleiter 10 ist beispielsweise mittels eines geeigneten Klebstoffs mit dem Lichtausgang 18 des Primäroptikelements 5 verbunden. Alternativ oder zusätzlich können der Wellenleiter 10 und das Primäroptikelement 5 auch mittels eines Verbindungsteckers miteinander verbunden sein. In diesem Fall kann das Primäroptikelement 5 auch einteilg mit dem Stecker ausgebildet und beispielsweise aus einem transparenten Kunststoff mittels Spritzgießen hergestellt sein.

Zwischen der Chipauskoppelfläche 4 des Halbleiterchips 3 und dem Lichteingang 17 besteht ein Luftspalt 19. Dadurch wird der hochdivergente Anteil des in das Primäroptikelement 5 gelangenden Lichts geschwächt, wie im allgemeinen Teil der Beschreibung dargelegt.

In Figur 3b ist zusätzlich ein Rahmen 13 des Scheinwerferelements gezeigt. Die Innenwand 20 dieses Rahmens 13 sowie der Träger 15 ist aus einem reflektierenden Material gefertigt, so dass ein Teil der Lichtstrahlen, die nicht direkt in das Primäroptikelement gelangen, an diesen derart mehrfach reflektiert wird, dass sie mit einem geringeren Winkel zur Hauptabstrahlrichtung des Halbleiterchips 3 auf den Lichteingang 17 des Primäroptikelements gelenkt werden. Der Rahmen 13 kann hierbei einteilig mit dem Träger 12 ausgebildet sein.

Alternativ kann der Halbleiterchip 3 auch in dem Material des Primäroptikelements 5 eingebettet sein oder kann dessen Chipauskoppelfläche direkt an den Lichteingang 17 anschließen.

Zumindest ein Teil der den Lichteingang 17 mit dem Lichtausgang 18 verbindenden Seitenfläche des Grundkörpers des Primäroptikelements 5 kann mit einer reflektierenden Schicht (z.B. A1) versehen sein, derart, dass in den Lichteingang 17 eingekoppelte Lichtstrahlen, welche die Bedingung der Totalreflexion an der Seitenfläche nicht erfüllen, dennoch an dieser reflektiert werden. Insbesondere bei dem an den Lichteingang 17 angrenzenden Teil der Seitenfläche kann dies zweckmäßig sein.

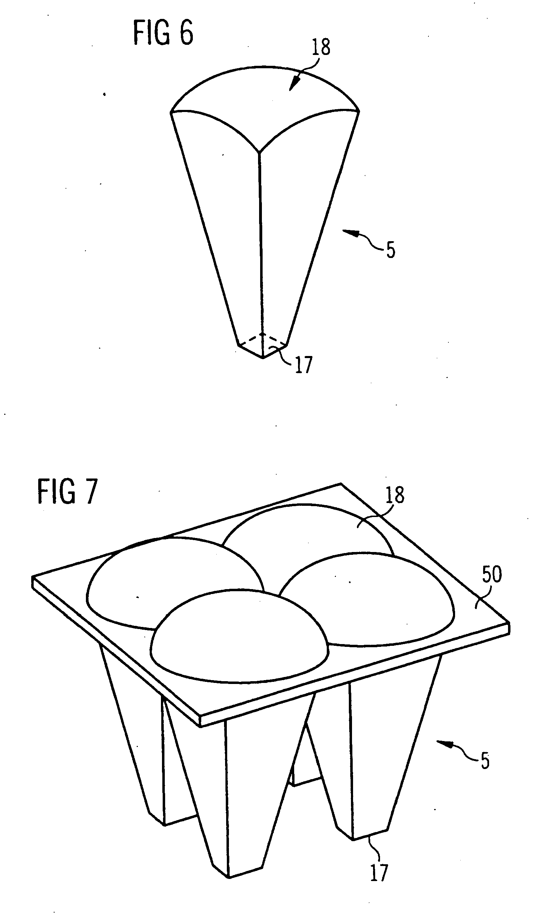

Das in Figur 6 dargestellte Primäroptikelement 5 weist im Unterschied zu den in den Figuren 1 bis 3b dargestellten Primäroptikelementen Seitenwände auf, die in geraden Linien von dem Lichteingang 17 zum Lichtausgang 18 verlaufen. Das Primäroptikelement 5 ist ein dielektrischer Konzentrator mit einer kegelstumpfartigen Grundform, wobei der Lichtausgang 18 nicht eben, sondern in der Art einer asphärischen Linse nach außen gewölbt ist. Verglichen mit einer sphärischen Wölbung nimmt die Wölbung beispielsweise mit zunehmendem Abstand von der optischen Achse des Primäroptikelementes ab, um dem Umstand Rechnung zu tragen, dass der Lichtkegel, dessen Divergenz durch das Primäroptikelement zu verringern ist, keine punktförmige Lichtquelle sondern eine Lichtquelle mit einer gewissen Ausdehnung ist.

Ein Primäroptikelement wie das in Figur 6 dargestellte hat verglichen mit den in den Figuren 1 bis 3b dargestellten Primäroptikelementen 5 den Vorteil, dass mit ihm eine vergleichbare Verringerung der Divergenz eines Lichtkegels bei gleichzeitig signifikanter Verringerung der Bauhöhe des Primäroptikelements 5 erzielt werden kann. Ein weiterer Vorteil des in Figur 6 dargestellten Primäroptikelementes ist, dass dieses aufgrund seiner geraden Seitenflächen einfacher mittels einem Spritzverfahren wie beispielsweise Spritzgießen oder Spritzpressen, hergestellt werden kann.

Der Lichteingang weist z.B. eine Lichteingangsfläche auf, die etwa so groß ist wie eine Chipauskoppelfläche eines mit dem Primäroptikelement zu verwendenden Halbleiterchips. Dadurch kann eine besonders gute Ausnutzung der Divergenz verringernden Eigenschaften des Primäroptikelementes erreicht werden. Besonders bevorzugt ist die Lichteingangsfläche maximal 1,5 mal so groß wie die Chipsauskoppelfläche.

Es ist auch möglich, das Primäroptikelement z.B. mit einem Halbleiterchip zu verwenden, dessen Chipauskoppelfläche größer ist als die Lichteingangsfläche, was jedoch zu einer etwas geringeren Effektivität hinsichtlich emittierter Lichtstärke und Licht dichte führen kann. Simulationen haben in einem Beispiel ergeben, dass für den Fall einer etwas größeren Chipauskoppelfläche etwa 10 % weniger Lichtintensität in einen Raumwinkel von 15° abgestrahlt werden kann, als bei einer Chipauskoppelfläche, die etwas kleiner ist als die Lichteingangsfläche.

Insbesondere mittels einem Spritzverfahren ist es möglich, mehrere Primäroptikelemente einteilig miteinander auszubilden, wie als Beispiel in Figur 7 dargestellt. Die Primäroptikelemente 5 sind in diesem Ausführungsbeispiel durch eine Trägerplatte 50 miteinander verbunden, wobei die Trägerplatte nahe dem Lichtausgang 18 angeordnet ist, so dass von der einen Seite der Trägerplatte 50 her pyramidenstumpfartige Teile der Primäroptikelemente 5 ausgehen und auf der anderen Seite linsenartige Elemente ausgebildet sind, deren Außenfläche jeweils den Lichtausgang 18 der Primäroptikelemente 5 bildet.

Alternativ zu den anhand der Figuren 6 und 7 erläuterten Ausführungsbeispiele für Primäroptikelemente 5 können diese statt einer pyramidenartigen Grundform beispielsweise auch eine kegelstumpfartige Grundform oder eine Grundform mit einem rechteckigen Querschnitt aufweisen. Es ist ebenso denkbar, dass der quadratische Querschnitt der Primäroptikelemente in den Figuren 6 und 7 zum Lichtausgang 18 hin in eine Querschnittsform übergeht, die mehr als 4 Ecken aufweist, analog zu dem Ausführungsbeispiel, das vorhergehend anhand der Figuren 3a und 3b beschrieben wurde.

Weiterhin ist es möglich, dass das Primäroptikelement derart gestaltet ist, dass eine Divergenz von elektromagnetischer Strahlung in unterschiedlichen, parallel zu einer Hauptabstrahlrichtung des Primäroptikelementes verlaufenden Ebenen unterschiedlich stark verringert wird. Beispielsweise ist der Öffnungswinkel eines emittierten Lichtkegels in einer Ebene etwa 7° und in einer zu dieser Ebene senkrechten Ebene (Schnittfläche entlang einer Hauptabstrahllinie) etwa 10° groß.

Ebenso ist es möglich, dass CPC-, CEC- oder CHC-artige dielektrische Konzentratoren zur weiteren Verringerung der Divergenz eines Lichtkegels ebenfalls einen linsenartig gewölbten Lichtausgang aufweisen. Als Alternative zu einem dielektrischen Konzentrator kann der Konzentrator auch aus einem Hohlkörper mit reflektierenden Innenwänden bestehen, dessen Lichtausgang in Abstrahlrichtung des Konzentrators eine Linse nachgeordnet ist. Beispielsweise ist die Linse auf den Lichtausgang aufgesetzt.

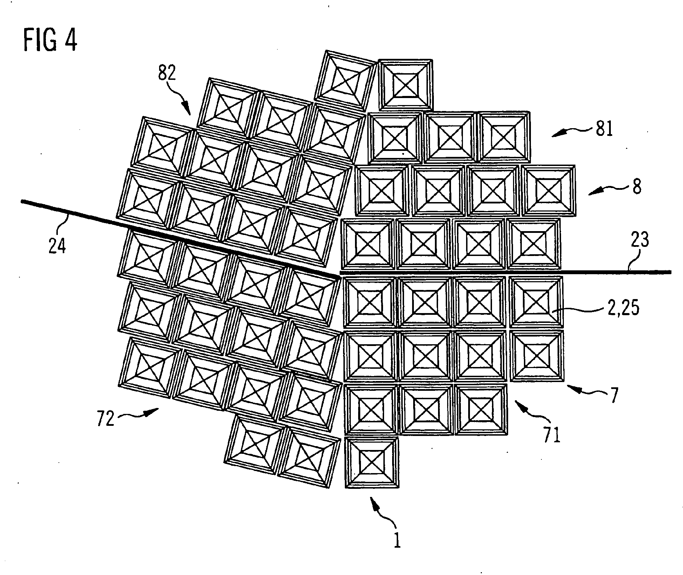

Figur 4 zeigt die Draufsicht eines Ausführungsbeispiels eines Scheinwerfers in Form eines Kfz-Scheinwerfers 1. Er besteht aus einer Vielzahl von Scheinwerferelementen 2, deren Scheinwerferelementausgänge 25 in Gruppen matrixartig sowie weitestgehend lückenlos angeordnet sind. Die Scheinwerferelemente 2 können beispielsweise so beschaffen sein wie in einem oder mehreren der anhand der Figuren 1 bis 3b erläuterten Ausführungsbeispiele beschrieben. So können insbesondere die Scheinwerferelementausgänge entweder Lichtausgänge der Primäroptiken oder Lichtauskoppelflächen von optischen Wellenleitern sein.

Unabhängig davon, dass die Scheinwerferelementausgänge 25 in Figur 4 eine quadratische Form aufweisen, können sie beliebig geformt sein, insbesondere auch drei-, sechs- oder achteckig oder auch rund sein.

Wenn die Scheinwerferelemente optische Wellenleiter aufweisen, können die jeweiligen Halbleiterchips anders als die Scheinwerferelementausgänge, beispielsweise nebeneinander in einer einzigen Zeile angeordnet sein. Für den Fall, dass die Wellenleiter mittels Verbindungssteckern mit dem Primäroptikelement verbunden sind, können alle Verbindungsstecker zusammen oder ein Teil von ihnen jeweils einteilig ausgebildet sein.

Die Scheinwerferelementausgänge 25 sind in zwei Gruppen 7, 8 eingeteilt, deren Trennungslinie in Figur 4 durch die zwei Linien 23, 24 angedeutet ist, wobei die untere Gruppe 7 den Scheinwerferausgang eines Abblendlichts bildet und die obere Gruppe 8 gemeinsam mit der unteren Gruppe 7 den eines Fernlichts bildet. Die Halbleiterchips der zu der unteren Gruppe 7 gehörenden Scheinwerferelemente 2 kann unabhängig von anderen Halbleiterchips in Betrieb genommen werden. Damit man ein einen Scheinwerferkelgel mit der Abstrahlcharakteristik eines Fernlichts erhält, können die Halbleiterchips der zu der oberen Gruppe 8 gehörenden Scheinwerferelemente zusätzlich zu denen der unteren Gruppe 7 in Betrieb genommen werden.

Beide Gruppen weisen jeweils zwei Untergruppen 71, 72 und 81, 82 auf, von denen jeweils eine entlang einem der Linien 23, 24 angeordnet ist, wobei die erste Linie 24 um 15° gegenüber dem anderen Linie 23 gedreht ist. Dies ergibt einen Scheinwerferkegel für das Abblendlicht (Gruppen 71, 72), der im Wesentlichen dem deutschen Standard ECE entspricht, nach dem dieser auf der in Abstrahlrichtung des Scheinwerfers linken Seite (entspricht Gruppe 72) eine horizontal verlaufende Obergrenze aufweisen muß, derart, dass Fahrer entgegenkommender Fahrzeuge nicht geblendet werden.

Die rechte Seite des Scheinwerferkegels (entspricht Gruppe 71) weist dagegen eine Obergrenze auf, die in einer um 15° gegenüber der Horizontalen verkippten Ebene liegt, derart, dass der in Fahrtrichtung rechts liegende Teil der Straße oder des Straßenrandes besser bzw. in Fahrtrichtung weiter durch den Scheinwerfer ausgeleuchtet ist als der linke Teil.

Bei eingeschaltetem Fernlicht werden die zu den höher liegenden Scheinwerferlementausgängen gehörenden Halbleiterchips hinzugeschaltet, so dass der resultierende Scheinwerferkegel insgesamt einen insbesondere in Fahrtrichtung weiter reichenden Teil der Fahrbahn beleuchtet.

Die Anordnung der Gruppen und Untergruppen kann auf einfache Weise den rechtlichen Vorgaben verschiedenenr Länder angepaßt werden.

Den Scheinwerferelementausgängen kann zur weiteren Verringerung der Divergenz des Scheinwerferlichts eine Kondensorlinse nachgeordnet sein (nicht gezeigt).

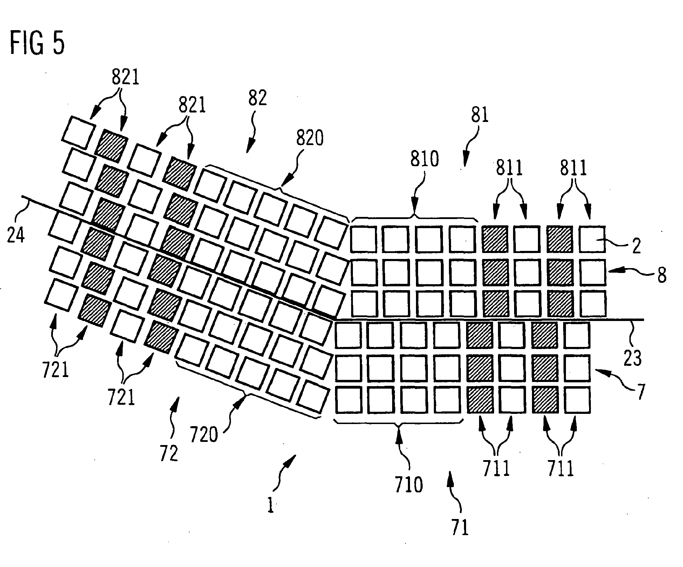

Figur 5 zeigt ein weiteres Ausführungsbeispiel eines Scheinwerfers. Dieser ist ebenfalls ein Kfz-Scheinwerfer 1, dessen Scheinwerferelementausgänge entsprechend des ECE-Standards angeordnet sind.

Im Unterschied zu dem anhand der Figur 4 erläuterteten Ausführungsbeispiel weist der in Figur 5 gezeigte Scheinwerfer Peripheriegruppen von Scheinwerferelementausgängen 711, 811, 721, 821 auf, deren entsprechenden Halbleiterchips jeweils entsprechend der Lenkstellung des Fahrzeugs derart an- oder ausgeschaltet werden, dass der vom Scheinwerfer abgestrahlte Lichtkegel der Fahrtrichtung des Kraftfahrzeugs zumindest teilweise folgt.

Die Mittengruppen 710, 720, 810, 820, werden unabhängig von der Lenkstellung beispielsweise manuell vom Fahrer an oder ausgeschaltet, abhängig davon, ob Abblendlicht oder Fernlicht eingeschaltet wird.

Es können bei gerader Lenkstellung und eingeschaltetem Abblendlicht z.B. die Halbleiterchips der Mittengruppen 710, 720 sowie je eine der an diese angrenzenden Peripheriegruppen 711 und 721 eingeschaltet sein. Wird die Lenkstellung in Richtung der in Fahrtrichtung linken Peripheriegruppen 711 geändert, so wird von diesen z.B. eine weitere eingeschaltet und die bis dahin eingeschaltete rechte Peripheriegruppe 721 dafür zumindest teilweise ausgeschaltet.

Die obige Erläuterung der Erfindung anhand der Ausführungsbeispiele ist selbstverständlich nicht als eine Beschränkung der Erfindung auf diese zu verstehen. So beschränkt sich die Erfindung keinesfalls auf Kfz-Scheinwerfer sondern umfasst alle denkbaren Scheinwerferarten. Die Erfindung eignet sich insbesondere auch für eine Projektionslichtquelle. Weitergehend können hierbei z.B. unabhängig voneinander in Betrieb nehmbare Halbleiterchips für eine sequentielle Projektion verschiedener Projektionsbilder und/oder verschiedener Farben verwendet werden.

Zudem kann ein Scheinwerfer auch mehrere Halbleiterchips pro Scheinwerferelement aufweisen und/oder Halbleiterchips verschiedener Emissionsfarben aufweisen, beispielsweise rot, grün und blau. Die den verschiedenfarbig emittierenden Halbleiterchips zugeordneten Scheinwerferelementausgänge können dann z.B. miteinander durchmischt angeordnet sein, derart, dass das Licht verschiedener Scheinwerferelementausgänge nachfolgend durchmischt wird und effektiv weißes Licht ergibt.

Merkmale die anhand unterschiedlicher Ausführungsbeispiele erläutert wurden sind unabhängig vom Ausführungsbeispiel beliebig miteinander kombinierbar. Die Erfindung umfasst jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Scheinwerferelement (2) mit
- mindestens einem elektromagnetische Strahlung emittierenden Halbleiterchip (3), der eine Chipauskoppelfläche (4) aufweist, durch die elektromagnetische Strahlung ausgekoppelt wird,
- einem Primäroptikelement (5), das einen Lichteingang (17) und einen Lichtausgang (18) aufweist und das die Divergenz eines durch den Lichteingang (17) einfallenden Lichtes verringert, wobei das Licht zumindest ein Teil der elektromagnetischen Strahlung und/oder zumindest ein Teil einer aus der elektromagnetischen Strahlung erzeugten Sekundärstrahlung ist, und
- mindestens einem Scheinwerferelementausgang, aus dem ein Teil eines Scheinwerferlichts aus dem Scheinwerferelement (2) abgestrahlt wird,
**dadurch gekennzeichnet, dass**
das Primäroptikelement (5) ein optischer Konzentrator ist, wobei der Lichteingang (17) der eigentliche Konzentratorausgang ist, so dass Licht, verglichen mit der üblichen Anwendung eines Konzentrators zum Fokussieren, in umgekehrter Richtung durch diesen läuft und somit nicht konzentriert wird, sondern den Konzentrator mit verringerter Divergenz durch den Lichtausgang (18) verlässt.

2. Scheinwerferelement (2) nach Anspruch 1,
**dadurch gekennzeichnet, dass**
der Konzentrator den Lichteingang (17) mit dem Lichtausgang (18) verbindende Seitenwände aufweist, die derart ausgebildet sind, dass auf den Seitenwänden verlaufende direkte Verbindungslinien zwischen dem Lichtein- und dem Lichtausgang (18) im wesentlichen gerade verlaufen.

3. Scheinwerferelement (2) nach Anspruch 1 oder 2,
**dadurch gekennzeichnet, dass**
der Lichtausgang (18) eine linsenartig gewölbte Grenzfläche des Vollkörpers ist.

4. Scheinwerferelement (2) nach Anspruch 3,
**dadurch gekennzeichnet, dass**
der Lichtausgang (18) in der Art einer asphärischen Linse gewölbt ist.

5. Scheinwerferelement (2) nach einem der Ansprüche 1 bis 4,
**dadurch gekennzeichnet, dass**
der Konzentrator in einem Bereich auf der Seite des Lichteingangs (17) eine Querschnittsfläche in Form eines regelmäßigen Vielecks, bevorzugt eine quadratische Querschnittsfläche aufweist und dass er in einem Bereich auf der Seite des Lichtausgangs (18) ebenfalls eine Querschnittsfläche in Form eines regelmäßigen Vielecks, bevorzugt eine drei-, vier-, sechs- oder achteckige Querschnittsfläche aufweist.

6. Scheinwerferelement (2) nach einem der Ansprüche 1 bis 5,
**dadurch gekennzeichnet, dass**
der Konzentrator ein dieelektrischer Konzentrator ist, dessen Grundkörper ein aus einem dieelektrischen Material mit geeignetem Brechungsindex bestehender Vollkörper ist, so dass über den Lichteingang (17) eingekoppeltes Licht in diesem durch Totalreflexion an der den Lichteingang (17) mit dem Lichtausgang (18) verbindenden seitlichen Grenzfläche des Vollkörpers zur Aussenatmosphäre reflektiert wird.

7. Scheinwerferelement (2) nach Anspruch 6,
**dadurch gekennzeichnet, dass**
der dielektrische Konzentrator zumindest teilweise mit einer Schicht oder Schichtenfolge, bevorzugt mit einer metallischen Schicht versehen ist, die für von dem jeweiligen Halbleiterchip (3) ausgesandtes Licht reflektierend ist.

8. Scheinwerferelement (2) nach einem der Ansprüche 1 bis 7,
**dadurch gekennzeichnet, dass**
der Konzentrator dem Halbleiterchip (3) in dessen Hauptabstrahlrichtung nachgeordnet ist und dass zwischen der Chipauskoppelfläche (4) und dem Lichteingang (17) des Konzentrators ein Spalt (19) besteht.

9. Scheinwerferelement (2) nach Anspruch 8,
**dadurch gekennzeichnet, dass**
der Spalt (19) weitestgehend frei von fester oder viskoser Materie ist.

10. Scheinwerferelement (2) nach einem der Ansprüche 8 und 9,
**dadurch gekennzeichnet, dass**
das Scheinwerferelement (2) ein oder mehrere Reflektorelemente aufweist, die derart angeordnet und/oder von solcher Form sind, dass ein Großteil der Lichtstrahlen, die nicht direkt vom Halbleiterchip (3) in den Konzentrator gelangen, an diesen mehrfach reflektiert werden und unter mit einem geringeren Winkel zur Hauptabstrahlrichtung des Halbleiterchips (3) auf den Lichteingang (17) des Konzentrators gelenkt werden.

11. Scheinwerferelement (2) nach einem der Ansprüche 1 bis 10,
**dadurch gekennzeichnet, dass**
der Grundkörper des Konzentrators aus einem transparenten Glas, einem transparenten Kristall oder einem transparenten Kunststoff besteht und dass er bevorzugt in einem Spritzpress- und/oder einem Spritzgussverfahren gefertigt ist.

12. Scheinwerferelement (2) nach einem der Ansprüche 1 bis 11,
**dadurch gekennzeichnet, dass**
der Lichtausgang (18) des Konzentrators der Scheinwerferelementausgang ist.

13. Scheinwerferelement (2) nach einem der Ansprüche 1 bis 12,
**dadurch gekennzeichnet, dass**
dem Konzentrator ein optischer Wellenleiter (10) (10), bevorzugt eine Glasfaser oder ein Bündel mit mehreren Glasfasern in Abstrahlrichtung der Primäroptik nachgeordnet ist, mit einer Lichteingangsfläche (20) und einer Lichtausgangsfläche, in den zumindest ein Großteil des aus dem Lichtausgang (18) des Konzentrators ausgestrahlten Lichtes durch die Lichteingangsfläche (20) übergeht.

14. Scheinwerferelement (2) nach Anspruch 13 unter Rückbezug auf einen der Ansprüche 1 bis 11,
**dadurch gekennzeichnet, dass**
die Lichtausgangsfläche des optischen Wellenleiters (10) der Scheinwerferelementausgang ist.

15. Scheinwerferelement (2) nach einem der Ansprüche 13 und 14,
**dadurch gekennzeichnet, dass**
der optische Wellenleiter (10) mit dem entsprechenden Konzentrator einteilig ausgebildet ist.

## Claims

1. Headlight element (2), with
- at least one semiconductor chip (3) which emits electromagnetic radiation which has a chip output surface (4) through which electromagnetic radiation is emitted,
- a primary optics element (5), which has a light input (17) and a light output (18) and which reduces the divergence of the light which is incident through the light input (17), with the light being at least part of the electromagnetic radiation and/or at least part of a secondary radiation which is produced from the electromagnetic radiation,
and
- at least one headlight element output, which emits a part of the headlight light from the headlight element (2),
**characterized in that**
the primary optics element (5) is an optical concentrator, with the light input (17) being the actual concentrator output, so that light passes through this in the opposite direction compared with the normal use of a concentrator for focusing, and is thus not concentrated, but leaves the concentrator through the light output (18) with reduced divergence.

2. Headlight element (2) according to Claim 1,
**characterized in that**
the concentrator has side walls which connect the light input (17) to the light output (18) and are designed in such a way that direct connecting lines which run on the side walls run essentially in a straight line between the light input and the light output (18).

3. Headlight element (2) according to Claim 1 or 2,
**characterized in that**
the light output (18) is a boundary surface of the solid body that is curved in the manner of a lens.

4. Headlight element (2) according to Claim 3,
**characterized in that**
the light output (18) is curved in the manner of an aspherical lens.

5. Headlight element (2) according to one of Claims 1 to 4,
**characterized in that**
the concentrator has a cross-sectional surface in the form of a regular polygon, preferably a square cross-sectional surface, in an area on the side of the light input (17), and **in that** it likewise has a cross-sectional surface in the form of a regular polygon, preferably a triangular, quadrilateral, hexagonal or octagonal cross-sectional surface, in an area on the side of the light output (18).

6. Headlight element (2) according to one of Claims 1 to 5,
**characterized in that**
the concentrator is a dielectric concentrator, whose base body is a solid body which is composed of a dielectric material with a suitable refractive index such that light which is injected via the light input (17) is reflected in this by total internal reflection on the side boundary surface of the solid body, which connects the light input (17) to the light output (18), to the external atmosphere.

7. Headlight element (2) according to Claim 6,
**characterized in that**
the dielectric concentrator is provided at least in places with a layer or layer sequence, preferably with a metallic layer, which is reflective for the light which is emitted from the respective semiconductor chip (3).

8. Headlight element (2) according to one of Claims 1 to 7,
**characterized in that**
the concentrator is arranged downstream from the semiconductor chip (3) in its main emission direction, and **in that** there is a gap (19) between the chip output surface (4) and the light input (17) of the concentrator.

9. Headlight element (2) according to Claim 8,
**characterized in that**
the gap (19) is to a large extent free of solid or viscous materials.

10. Headlight element (2) according to one of Claims 8 and 9,
**characterized in that**
the headlight element (2) has one or more reflector elements which are arranged in such a way, and/or are of such a shape that the majority of the light beams which do not pass directly from the semiconductor chip (3) into the concentrator are reflected a plurality of times on it and are deflected at a smaller angle than the main emission direction of the semiconductor chip (3) to the light input (17) of the concentrator.

11. Headlight element (2) according to one of Claims 1 to 10,
**characterized in that**
the base body of the concentrator is composed of a transparent glass, a transparent crystal or a transparent plastic, and **in that** it is preferably manufactured using an injection-molding and/or transfer-molding process.

12. Headlight element (2) according to one of Claims 1 to 11,
**characterized in that**
the light output (18) of the concentrator is the headlight element output.

13. Headlight element (2) according to one of Claims 1 to 12,
**characterized in that**
the concentrator is followed by an optical waveguide (10), preferably a glass fiber or a bundle with a plurality of glass fibers, with a light input surface (20) and a light output surface, in the emission direction of the primary optics, into which at least the majority of the light which is emitted from the light output (18) of the concentrator is passed through the light input surface (20).

14. Headlight element (2) according to Claim 13 and referring back to one of Claims 1 to 11,
**characterized in that**
the light output surface of the optical waveguide (10) is the headlight element output.

15. Headlight element (2) according to one of Claims 13 and 14,
**characterized in that**
the optical waveguide (10) is formed integrally with the corresponding concentrator.

## Revendications

1. Élément de phare (2) avec
- au moins une puce semi-conductrice (3) émettant un rayonnement électromagnétique, comportant une surface de couplage en sortie de la puce (4) permettant la sortie du rayonnement électromagnétique,
- un élément optique primaire (5) comportant une entrée de lumière (17) et une sortie de lumière (18) et réduisant la divergence d'une lumière incidente à travers l'entrée de lumière (17), la lumière constituant au moins une partie du rayonnement électromagnétique et/ou au moins une partie d'un rayonnement secondaire généré à partir du rayonnement électromagnétique, et
- au moins une sortie de l'élément de phare à partir de laquelle une partie de la lumière du phare est émise à partir de l'élément de phare (2),
**caractérisé en ce que** l'élément optique primaire (5) est un concentrateur optique, l'entrée de lumière (17) étant en fait la sortie du concentrateur de telle sorte que la lumière se propage à travers celui-ci en sens inverse par rapport l'application habituelle d'un concentrateur destiné à la focalisation, et n'est de ce fait pas concentrée, mais quitte le concentrateur à travers la sortie de lumière (18) avec une divergence réduite.

2. Élément de phare (2) selon la revendication 1, **caractérisé en ce que** le concentrateur comporte des parois latérales reliant l'entrée de lumière (17) à la sortie de lumière (18), qui sont formées de telle sorte que des lignes de liaison directes se propagent pour l'essentiel en ligne droite sur les parois latérales entre l'entrée et la sortie de lumière (18).

3. Élément de phare (2) selon la revendication 1 ou 2, **caractérisé en ce que** la sortie de lumière (18) est une surface de séparation bombée à la manière de lentille du corps plein.

4. Élément de phare (2) selon la revendication 3, **caractérisé en ce que** la sortie de lumière (18) est bombée à la manière d'une lentille asphérique.

5. Élément de phare (2) selon une des revendications 1 à 4, **caractérisé en ce que** dans une zone latérale de l'entrée de lumière (17), le concentrateur comporte une surface de section transversale en forme d'un polygone régulier, de préférence une surface de section transversale carrée, et en ce dans une zone latérale de la sortie de lumière (18), il comporte également une surface de section transversale en forme d'un polygone régulier, de préférence une surface de section transversale à trois, quatre, six ou huit côtés.

6. Élément de phare (2) selon une des revendications 1 à 5, **caractérisé en ce que** le concentrateur est un concentrateur diélectrique, dont le corps de base est un corps plein constitué d'un matériau diélectrique avec l'indice de réfraction approprié, de telle sorte que la lumière couplée en entrée par l'intermédiaire de l'entrée de lumière (17) soit réfléchie dans celui-ci vers l'atmosphère extérieure par réflexion totale sur la surface de séparation latérale du corps plein, reliant l'entrée de lumière (17) à la sortie de lumière (18).

7. Élément de phare (2) selon la revendication 6, **caractérisé en ce que** le concentrateur diélectrique est pourvu au moins partiellement d'une couche ou d'une succession de couches, de préférence d'une couche métallique, qui est réfléchissante pour la lumière émise par la puce semi-conductrice (3) respective.

8. Élément de phare (2) selon une des revendications 1 à 7, **caractérisé en ce que** le concentrateur est disposé en aval de la puce semi-conductrice (3) dans sa direction de rayonnement principale et **en ce qu'**il subsiste une fente (19) entre la surface de couplage en sortie de la puce (4) et l'entrée de lumière (17) du concentrateur.

9. Élément de phare (2) selon la revendication 8, **caractérisé en ce que** la fente (19) est très largement exempte de matière solide ou visqueuse.

10. Élément de phare (2) selon une des revendications 8 et 9, **caractérisé en ce que** l'élément de phare (2) comporte un ou plusieurs éléments réflecteurs disposés et/ou d'une forme telle qu'une grande partie des rayons lumineux qui n'arrivent pas directement de la puce semi-conductrice (3) à l'intérieur du concentrateur, est réfléchie plusieurs fois sur celui-ci et est guidée vers l'entrée de lumière (17) du concentrateur sous un angle plus faible par rapport à la direction de rayonnement principale de la puce semi-conductrice (3).

11. Élément de phare (2) selon une des revendications 1 à 10, **caractérisé en ce que** le corps de base du concentrateur est constitué d'un verre transparent, d'un cristal transparent ou d'une matière plastique transparente et **en ce qu'**il est de préférence fabriqué dans un processus de moulage par transfert et/ou de moulage par injection.

12. Élément de phare (2) selon une des revendications 1 à 11, **caractérisé en ce que** la sortie de lumière (18) du concentrateur est la sortie de l'élément de phare.

13. Élément de phare (2) selon une des revendications 1 à 12, **caractérisé en ce qu'**un guide d'ondes optique (10), de préférence une fibre de verre ou un faisceau de plusieurs fibres de verre est disposé en aval de l'optique primaire dans la direction du rayonnement, avec une surface d'entrée de lumière (20) et une surface de sortie de lumière, dans lesquelles au moins une grande partie de la lumière émise à partir de la sortie de lumière (18) du concentrateur passe à travers la surface d'entrée de lumière (20).

14. Élément de phare (2) selon la revendication 13 avec référence à une des revendications précédentes 1 à 11, **caractérisé en ce que** la surface de sortie de lumière du guide d'ondes optique (10) est la sortie de l'élément de phare.

15. Élément de phare (2) selon une des revendications 13 et 14, **caractérisé en ce que** le guide d'ondes optique (10) forme une seule pièce avec le concentrateur correspondant.
